# EUROPEAN PATENT APPLICATION

(11) **EP 4 745 950 A1**
(43) Date of publication of application: **20.05.2026**
(21) Application number: 24877432.5
(22) Date of filing: 24.09.2024
(51) Int. Cl.: G09G 3/32

(54) **DISPLAY MODULE**

(30) Priority: 10.10.2023 KR 20230134402
(71) Applicant: Samsung Electronics Co., Ltd., Suwon-si, Gyeonggi-do 16677 (KR)
(72) Inventor: OH, Donggun, Suwon-si, Gyeonggi-do 16677 (KR); PARK, Wonkeun, Suwon-si, Gyeonggi-do 16677 (KR); SEO, Jeongphil, Suwon-si, Gyeonggi-do 16677 (KR); JUNG, Youngki, Suwon-si, Gyeonggi-do 16677 (KR)
(74) Representative: Gulde & Partner
(86) International application number: PCT/KR2024/014412
(87) International publication number: WO 2025/079894

(57) **Abstract**

A display module is disclosed. The disclosed display module comprises: a glass substrate; a thin film transistor (TFT) layer formed on one surface of the glass substrate; and a plurality of light-emitting diodes arranged on the TFT layer. The TFT layer includes a plurality of pixel circuits, which are arranged in a grid and are for driving the plurality of light-emitting diodes, and a plurality of gate in panel (GIP) circuits, which are spaced apart from each other in the thickness direction of the TFT layer with respect to the plurality of pixel circuits.

## Description

### [Technical Field]

The disclosure relates to a display module including a gate in panel (GIP) circuit structure.

### [Background Art]

A display substrate includes a TFT layer including a plurality of thin film transistors (TFTs) and a plurality of light-emitting diodes mounted on the TFT layer. The plurality of light-emitting diodes express various colors as they are operated in pixel or subpixel units. Operations of each pixel or subpixel are controlled by the plurality of TFTs. Each light-emitting diode emits various colors, e.g., a red color, a green color, and a blue color.

### [Disclosure of Invention]

### [Solution to Problem]

A display module according to one or more embodiments of the disclosure may include a glass substrate, a thin film transistor (TFT) layer formed on one surface of the glass substrate, and a plurality of light-emitting diodes arranged on the TFT layer. The TFT layer may include a plurality of pixel circuits which are arranged in a grid and are for driving the plurality of light-emitting diodes, and a plurality of gate in panel (GIP) circuits which are spaced apart from one another along a thickness direction of the TFT layer with respect to the plurality of pixel circuits.

The TFT layer may include a plurality of metal layers which are sequentially stacked to be spaced apart. Each of the plurality of pixel circuits may be formed on some of the plurality of metal layers. The plurality of GIP circuits may be formed on the remaining layers of the plurality of metal layers.

The TFT layer may include a first metal layer, a second metal layer, a third metal layer, and a fourth metal layer which are sequentially stacked to be spaced apart. Each of the plurality of pixel circuits may be formed on the first metal layer and the second metal layer. Each of the plurality of GIP circuits may be formed on the third metal layer and the fourth metal layer.

The plurality of metal layers may further include a fifth metal layer which is stacked to be spaced apart on the upper side of the fourth metal layer. On the fifth metal layer, a pixel electrode to which the plurality of light-emitting diodes are electrically connected may be formed.

The plurality of metal layers may include an LTPS TFT, and the plurality of GIP circuits may include an oxide TFT.

The plurality of pixel circuits may include an LTPS TFT, and the plurality of GIP circuits may include an LTPS TFT.

The plurality of pixel circuits may include an oxide TFT, and the plurality of GIP circuits may include an oxide TFT.

The plurality of light-emitting diodes may be micro LEDs.

A portion of the plurality of GIP circuits may overlap with one of the plurality of light-emitting diodes.

A display module according to one or more embodiments may include a substrate, a thin film transistor (TFT) layer which is provided on one surface of the substrate, and includes a plurality of pixel circuits and at least one gate in panel (GIP) circuit arranged at a different height from the plurality of pixel circuits, and a plurality of micro LEDs arranged on the plurality of TFT layers.

The TFT layer may further include a first metal layer on which the plurality of pixel circuits are formed and a second metal layer on which the first metal layer is stacked to be spaced apart.

The TFT layer may further include three or more metal layers on which the at least one GIP circuit is formed.

The plurality of pixel circuits may include an LTPS TFT.

The at least one GIP circuit may include an oxide TFT or an LTPS TFT.

The plurality of pixel circuits and the at least one GIP circuit may include an oxide TFT.

### [Brief Description of Drawings]

FIG. 1 is a diagram illustrating a display module according to one or more embodiments;
FIG. 2 is a diagram illustrating a pixel structure of a display module according to an embodiment of the disclosure, and is a diagram that enlarged the A portion displayed in FIG. 1;
FIG. 3 is a diagram illustrating arrangement of circuit areas arranged on a front surface of a display module according to one or more embodiments;
FIG. 4 is a diagram illustrating a plurality of pixel circuits and a plurality of gate in panel (GIP) circuits of a display module according to one or more embodiments, and is a diagram that enlarged the B portion displayed in FIG. 3;
FIG. 5 is a diagram schematically illustrating a stack structure of metal layers provided on a TFT layer of a display module according to one or more embodiments;
FIG. 6 is a cross-sectional view illustrating an example wherein pixel circuits provided on a TFT layer of a display module according to one or more embodiments consist of an LTPS TFT, and GIP circuits consist of an oxide TFT;
FIG. 7 is a diagram illustrating an example wherein some of a plurality of GIP circuits of a display module according to one or more embodiments overlap with a plurality of pixel circuits;
FIG. 8 is a cross-sectional view illustrating an example wherein all of pixel circuits and GIP circuits provided on a TFT layer of a display module according to one or more embodiments consist of an LTPS TFT;
FIG. 9 is a cross-sectional view illustrating an example wherein all of pixel circuits provided on a TFT layer of a display module according to one or more embodiments consist of an oxide TFT; and
FIG. 10 is a block diagram illustrating a display device according to one or more embodiments.

### [Mode for Invention]

The features illustrated in the embodiments and the drawings described in the disclosure are merely one or more preferable embodiments, and on the time point of filing of the disclosure, there may be various modified embodiments that can replace the embodiments and the drawings of the disclosure.

Also, in the disclosure, the same reference numerals or symbols suggested in each drawing refer to components or elements performing substantially the same functions.

In addition, the terms used in the disclosure are used to describe embodiments, and are not intended to restrict and/or limit the disclosed invention. Further, singular expressions include plural expressions, unless defined obviously differently in the context. Also, in this specification, terms such as "include" and "have" should be construed as designating that there are such characteristics, numbers, steps, operations, elements, components, or a combination thereof described in the specification, but not as excluding in advance the existence or possibility of adding one or more of other characteristics, numbers, steps, operations, elements, components, or a combination thereof.

Also, terms including ordinal numbers such as "the first," "the second," and the like used in the disclosure may be used to describe various elements, but the elements are not limited by the terms, and the terms are used only to distinguish one element from another element. For example, a first element may be called a second element, and a second element may be called a first element in a similar manner, without departing from the scope of protection of the disclosure. In addition, the term "and/or" includes a combination of a plurality of related items described, or any one item among a plurality of related items described.

Further, the terms "a front end," "a rear end," "an upper part," "a lower part," "a front surface," "a rear surface," "an upper surface," "a lower surface," "an upper end," "a lower end," "one end," "the other end," "the left side," and "the right side," etc. used in the disclosure were defined based on the drawings, and the shapes and the locations of each element are not limited by these terms.

Hereinafter, a display module according to one or more embodiments will be described with reference to the accompanying drawings.

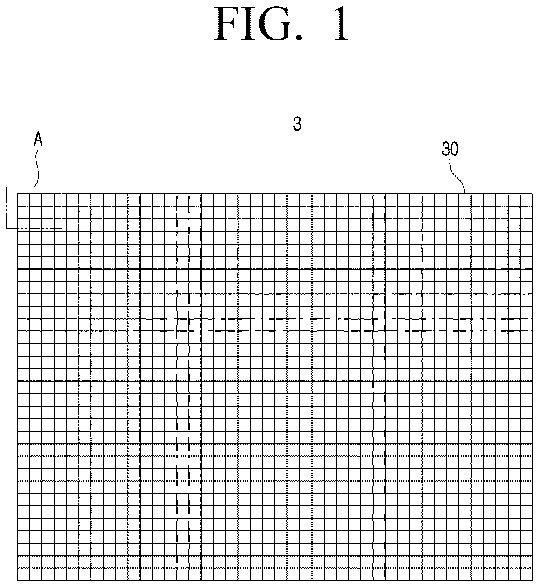

FIG. 1 is a diagram illustrating a display module according to one or more embodiments.

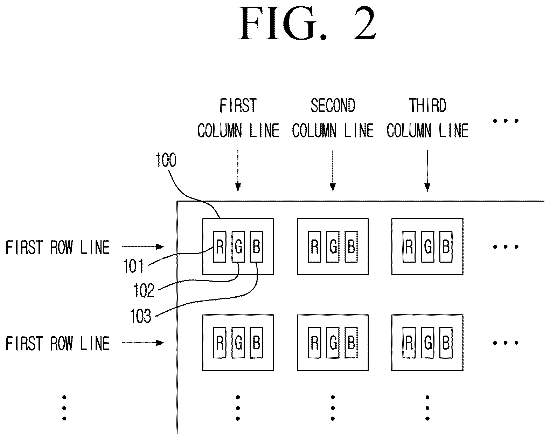

FIG. 2 is a diagram illustrating a pixel structure of a display module according to an embodiment of the disclosure, and is a diagram that enlarged the A portion displayed in FIG. 1.

Referring to FIG. 1 and FIG. 2, the display module 3 may include a substrate 30, and a pixel array provided on the front surface of the substrate 30.

The pixel array may include a plurality of pixels 100 arranged in a form of a matrix on the substrate 30. The pixel array may include a plurality of row lines or a plurality of column lines. A row line may be referred to as a horizontal line, and a column line may be referred to as a vertical line.

The plurality of pixels 100 may respectively include a plurality of light-emitting diodes 101, 102, 103. One light-emitting diode may also be referred to 'a subpixel,' and the same reference numeral may be used for a light-emitting diode and a subpixel. For example, each pixel 100 may include three types of subpixels such as a red (R) subpixel 101, a green (G) subpixel 102, and a blue (B) subpixel 103.

Each light-emitting diode 101, 102, 103 may be an inorganic light-emitting diode. For example, each pixel 100 may include three types of inorganic light-emitting diodes such as an R inorganic light-emitting diode corresponding to the R subpixel 101, a G inorganic light-emitting diode corresponding to the G subpixel 102, and a B inorganic light-emitting diode corresponding to the B subpixel 103.

Each pixel 100 may include three blue inorganic light-emitting diodes. In this case, on each inorganic light-emitting diode, a color filter for implementing R, G, B colors may be provided. Here, the color filter may be a quantum dot (QD) color filter, but is not limited thereto.

According to one or more embodiments, an inorganic light-emitting diode may be a micro light-emitting diode having a size of 100 *µ*m or smaller. The display module 3 may be a micro LED display module wherein each subpixel 101, 102, 103 is implemented as a micro LED. The micro LED display module 3 provides better contrast, response time, and energy efficiency than a liquid crystal display panel which needs a backlight. Meanwhile, both of an organic light-emitting diode and a micro LED have good energy efficiency, but a micro LED provides better performance than an OLED in the aspects of brightness, light emitting efficiency, and a lifespan. In particular, as a micro LED has a characteristic of having better efficiency when a relatively higher current than an OLED is used, the micro display module 3 may, for providing a stable high current, provide a driving voltage to a pixel circuit through a separate metal layer from a metal layer on which a gate electrode or a source electrode or a drain electrode of a thin film transistor (TFT) is formed.

According to one or more embodiments, on each subpixel 101, 102, 103, a first driving circuit for driving inorganic light-emitting diodes constituting the subpixel based on a data voltage applied through a data line may be provided. As the first driving circuit is provided for each subpixel, it may be referred to as a subpixel circuit. Between areas occupied by each pixel 100 in the display module 3, a second driving circuit for generating a control signal for driving the first driving circuit, and providing the generated control signal to the first driving circuit may be provided. Here, the second driving circuit may be, for example, a gate driving circuit (or a scan driving circuit). The gate driving circuit may be a gate in panel (GIP) circuit included together in a TFT layer including a pixel array. Hereinafter, the gate driving circuit will be referred to as 'a GIP circuit.'

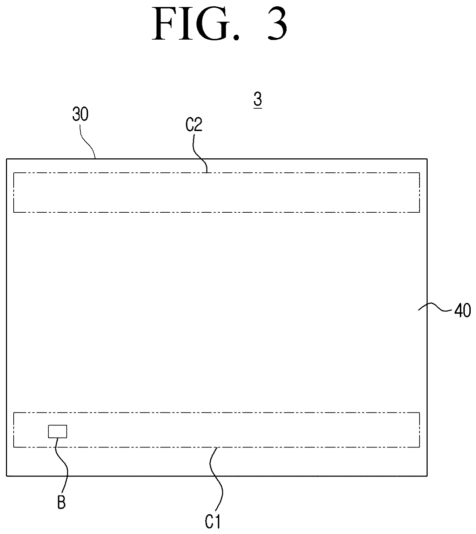

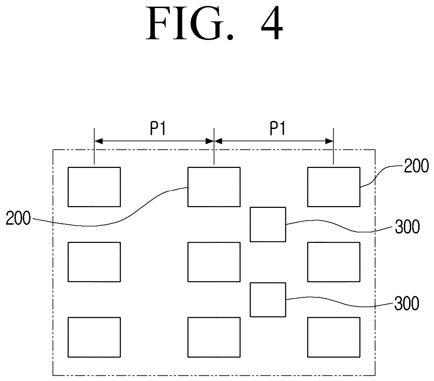

FIG. 3 is a diagram illustrating arrangement of circuit areas arranged on a front surface of a display module according to one or more embodiments. FIG. 4 is a diagram illustrating a plurality of pixel circuits and a plurality of gate in panel (GIP) circuits of a display module according to one or more embodiments, and is a diagram that enlarged the B portion displayed in FIG. 3.

Referring to FIG. 3, on the display module 3, a plurality of pixel circuits 200 may be provided in a grid arrangement over the entire areas of the TFT layer 40 provided on the front surface of the substrate 30.

For example, a plurality of GIP circuits 300 may be included in the TFT layer 40 corresponding to the lower area C1 of the substrate 30. In the lower area C1, a multiplexer (MUX) circuit, an electro static discharge (ESD) circuit, etc. may be provided together with the plurality of GIP circuits 300. For example, in the upper area C2 of the substrate 30, a plurality of data driving circuits, a MUX circuit, an ESD circuit, etc. may be provided.

Referring to FIG. 4, the plurality of GIP circuits 300 may be located in a specific area provided between the plurality of pixel circuits 200 arranged at a regular pixel pitch P1. In this case, the plurality of GIP circuits 300 may be located on a different layer from the plurality of pixel circuits 200 as will be described below. In this case, a separation distance between a plurality of GIP CLK wirings connected to the plurality of GIP circuits 300 and a plurality of data wirings overlapped with the plurality of GIP CLK wirings can be secured sufficiently. Accordingly, poor picture quality in a form of Mura due to coupling and an RC delay between the plurality of GIP CLK wirings and the plurality of data wirings can be prevented or improved. Here, Mura means a defect that a specific area of a screen is displayed unevenly when the entire screen is displayed in a regular grayscale.

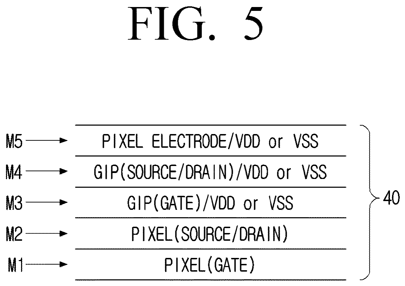

FIG. 5 is a diagram schematically illustrating a stack structure of metal layers provided on a TFT layer of a display module according to one or more embodiments.

Referring to FIG. 5, a first metal layer M1 and a second metal layer M2 may be provided on the TFT layer 40 of the display module 3. The second metal layer M2 may be provided on the upper side of the first metal layer M1 at a specific interval. In this case, between the first metal layer M1 and the second metal layer M2, at least one organic layer and at least one insulation layer may be provided.

Between the first metal layer M1 and the second metal layer M2, transistors corresponding to the pixel circuits 200 may be formed. For example, on the first metal layer M1, a gate electrode of the pixel circuits 200 may be formed, and on the second metal layer M2, a data electrode (i.e., a source electrode and a drain electrode) of the pixel circuits 200 may be formed.

On the TFT layer 40 of the display module 3, a third metal layer M3 and a fourth metal layer M4 may be further provided. The third metal layer M3 may be provided on the upper side of the second metal layer M2 at a specific interval. The fourth metal layer M4 may be provided on the upper side of the third metal layer M3 at a specific interval. In this case, each of between the second metal layer M2 and the third metal layer M3, and between the third metal layer M3 and the fourth metal layer M4, at least one organic layer and at least one insulation layer may be provided.

On the third metal layer M3 and the fourth metal layer M4, transistors corresponding to the GIP circuits 300 may be formed. For example, on the third metal layer M3, a gate electrode of the GIP circuits 300 may be formed, and on the fourth metal layer M4, a data electrode (i.e., a source electrode and a drain electrode) of the GIP circuits 300 may be formed.

Also, on the third metal layer M3 and the fourth metal layer M4, electrodes for providing operation power to the plurality of pixel circuits 200 constituted by the transistors included in the first and second metal layers M1, M2 may be formed.

Specifically, in the third metal layer M3, an electrode for providing a driving voltage (VDD) may be included. In the fourth metal layer M4, an electrode for providing a ground voltage (VSS) may be included. Alternatively, in contrast, an electrode for providing a ground voltage (VSS) may be included in the third metal layer M3. Also, in the fourth metal layer M4, an electrode for providing a driving voltage (VDD) may be included.

The material constituting the first, second, third, and fourth metal layers M1, M2, M3, M4 may be conductive metal, but is not limited thereto. For example, the material constituting the first, second, third, and fourth metal layers M1, M2, M3, M4 can be any metal material used in making the TFT layer 40 in a stack structure. As a detailed content in this regard is not related to the gist of the disclosure, detailed explanation will be omitted.

On the TFT layer 40 of the display module 3, a fifth metal layer M5 may be further provided. On the fifth metal layer M5, an electrode for electrically connecting the pixel circuits 200 and the plurality of light-emitting diodes 101, 102, 103, i.e., a pixel electrode may be formed. Between the fourth metal layer M4 and the fifth metal layer M5, at least one organic layer and at least one insulation layer may be provided.

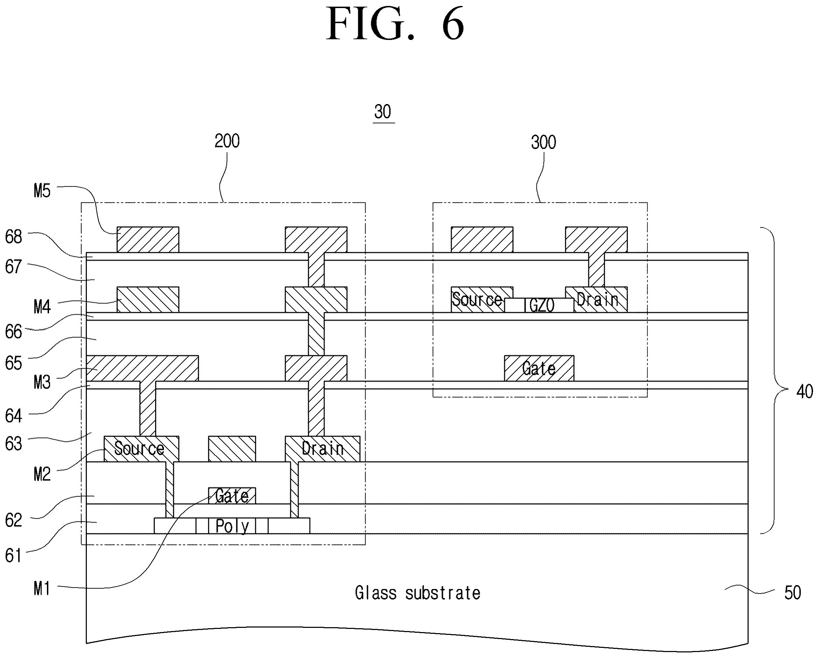

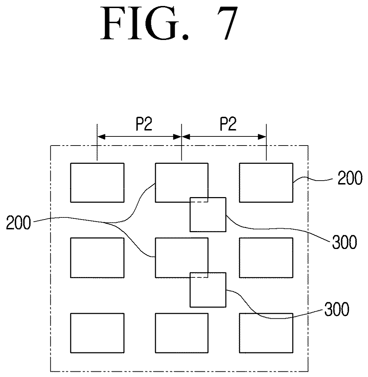

FIG. 6 is a cross-sectional view illustrating an example wherein pixel circuits provided on a TFT layer of a display module according to one or more embodiments consist of an LTPS TFT, and GIP circuits consist of an oxide TFT. FIG. 7 is a diagram illustrating an example wherein some of a plurality of GIP circuits of a display module according to one or more embodiments overlap with a plurality of pixel circuits.

Referring to FIG. 6, the substrate 30 of the display module 3 may include a glass substrate 50 and a TFT layer 40 formed on the glass substrate 50. In the TFT layer 40, pixel circuits 200, and GIP circuits 300 located on a different layer from the pixel circuits 200, may be included. On the TFT layer 40, first, second, third, fourth, and fifth metal layers M1, M2, M3, M4, M5 may be provided.

As in FIG. 6, transistors corresponding to the pixel circuits 200 use the first and second metal layers M1, M2, and may consist of a low-temperature polycrystalline silicon (LTPS) TFT.

The pixel circuits 200 may include a semiconductor channel layer (poly) formed on the glass substrate 50. On the channel layer, a gate electrode of a transistor formed on the first metal layer M1 may be provided. According to a voltage applied to the gate electrode, the channel layer gets to be opened or closed. Accordingly, a flow of data between a source electrode and a drain electrode formed on the second metal layer M2 may be controlled. On the third metal layer M3 and the fourth metal layer M4, a driving voltage (VDD) electrode or a ground voltage (VSS) electrode may be respectively formed, and on the fifth metal layer M5, a pixel electrode (IOT) may be formed.

Transistors corresponding to the GIP circuits 300 may consist of an oxide TFT, and may be formed on the third and fourth metal layers M3, M4 different from the first and second metal layers M1, M2 on which the pixel circuits 200 are formed. Accordingly, the GIP circuits 300 may be provided in a higher location than the location of the pixel circuits 200. In other words, the GIP circuits 300 may be arranged to be separated from the pixel circuits 200 along a thickness direction of the TFT layer 40.

On the GIP circuits 300, the gate electrode of the transistor formed on the first metal layer M1 may be provided. On the upper side of the gate electrode, an active layer (IGZO, Indium/Gallium/Zinc/Oxygen) may be arranged to be spaced apart. The active layer (IGZO) may mean a channel layer on which electrons move. According to a voltage applied to the gate electrode, the channel layer gets to be opened or closed. Accordingly, a flow of data between a source electrode and a drain electrode formed on the fourth metal layer M4 may be controlled.

As described above, the display module 3 according to one or more embodiments may consist of dual channels wherein the plurality of pixel circuits 200 and the plurality of GIP circuits 300 are located on different layers, but not a single channel wherein they are located on the same layer within the TFT layer 40 of the substrate 30.

Referring to FIG. 7, as the plurality of GIP circuits 300 are located on a different layer from the plurality of pixel circuits 200, they may be provided in a location wherein at least some of the plurality of pixel circuits 200 are overlapped. In this case, as the pixel pitch P2 of the plurality of pixel circuits 200 can be reduced, a high resolution can be implemented.

Referring to FIG. 6, between the semiconductor channel layer and the first metal layer M1, a gate insulator (GI) 61 may be formed. Also, between the first metal layer M1 and the second metal layer M2, inter layer dielectrics (ILD) 62 may be formed. The gate insulator 61 and the inter layer dielectrics 62 may be inorganic insulators.

Also, between the second metal layer M2 and the third metal layer M3, between the third metal layer M3 and the fourth metal layer M4, and between the fourth metal layer M4 and the fifth metal layer M5, first, second, and third organic insulation layers 63, 65, 67 may be respectively formed. In this case, the thickness of the first, second, and third organic insulation layers 63, 65, 67 may be formed to be bigger than the thickness of the gate insulator 61 and the inter layer dielectrics 62 which are inorganic insulators.

In addition, between the first organic insulation layer 63 and the third metal layer M3, between the second organic insulation layer 65 and the fourth metal layer M4, and between the third organic insulation layer 67 and the fifth metal layer M5, first, second, and third passivation layers 64, 66, 68 for protecting the first, second, and third organic insulation layers 63, 65, 67 may be respectively formed.

The GIP circuits 300 are not limited to being formed only on the third metal layer M3 and the fourth metal layer M4. For example, in case six or more metal layers are stacked to be spaced apart, the GIP circuits 300 may be formed on the fourth metal layer M4 or metal layers higher than the fourth metal layer M4, which are higher than the metal layers on which the pixel circuits 200 are formed (the first metal layer M1 and the second metal layer M2). Also, in case the pixel circuits 200 are formed on the third metal layer M3 and the fourth metal layer M4, the GIP circuits 300 may be formed on the fifth metal layer M5 or metal layers higher than the fifth metal layer M5.

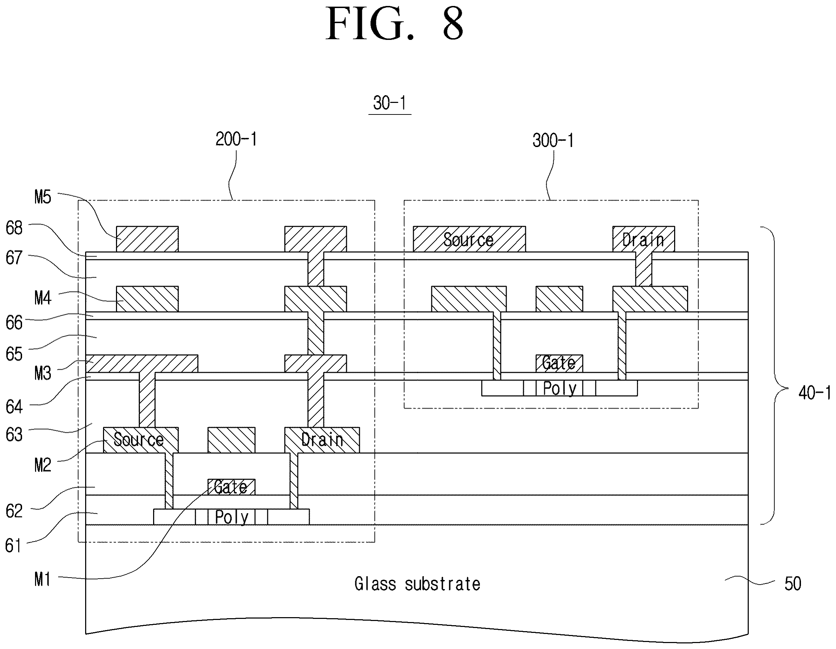

FIG. 8 is a cross-sectional view illustrating an example wherein all of pixel circuits and GIP circuits provided on a TFT layer of a display module according to one or more embodiments consist of an LTPS TFT.

Referring to FIG. 8, transistors corresponding to the pixel circuit 200-1 use the first and second metal layers M1, M2, and may consist of a low-temperature polycrystalline silicon (LTPS) TFT. In this case, transistors corresponding to the GIP circuit 300-1 use the third and fourth metal layers M3, M4, and may consist of the same LTPS TFT as the pixel circuit 200-1.

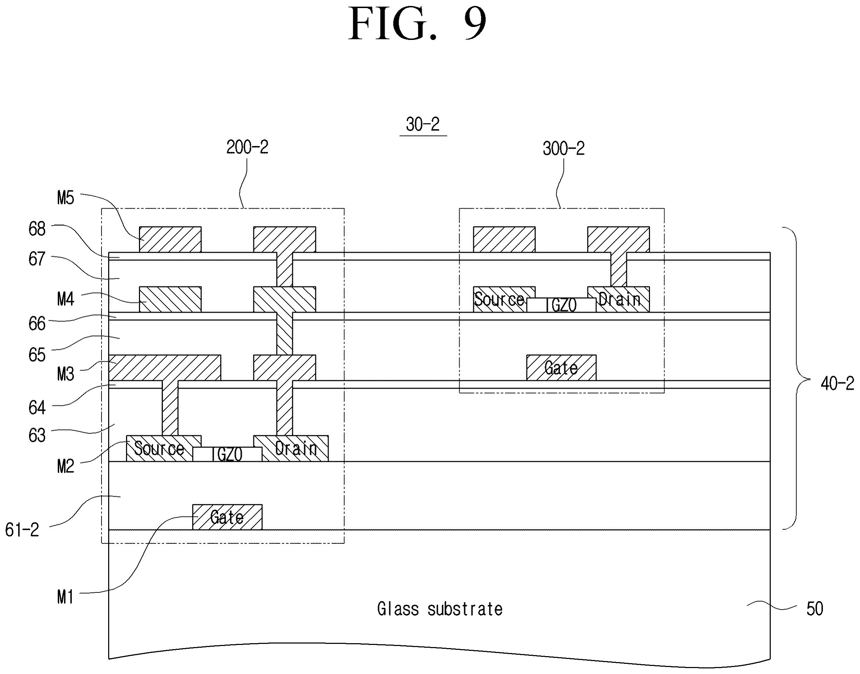

FIG. 9 is a cross-sectional view illustrating an example wherein all of pixel circuits provided on a TFT layer of a display module according to one or more embodiments consist of an oxide TFT.

Referring to FIG. 9, transistors corresponding to the pixel circuit 200-2 use the first and second metal layers M1, M2, and may consist of an oxide TFT. In this case, between the first metal layer M1 and the second metal layer M2, an organic insulation layer 61-2 may be formed.

In case the transistors corresponding to the pixel circuit 200-2 consist of an oxide TFT, transistors corresponding to the GIP circuit 300-2 use the third and fourth metal layers M3, M4, and may consist of the same oxide TFT as the pixel circuit 200-2.

In the display module 3 according to one or more embodiments, the plurality of pixel circuits 200, 200-1, 200-2 and the plurality of GIP circuits 300, 300-1, 300-2 are formed on metal layers of different layers, and thus a separation distance can be secured. Accordingly, poor picture quality in a form of Mura due to coupling and an RC delay can be prevented or improved.

In the display module 3 according to one or more embodiments, the plurality of pixel circuits 200, 200-1, 200-2 and the plurality of GIP circuits 300, 300-1, 300-2 may be formed on different metal layers, but not the same metal layer. Accordingly, a pixel pitch P2 among the adjacent pixel circuits 200, 200-1, 200-2 can be reduced, and thus a high resolution can be implemented.

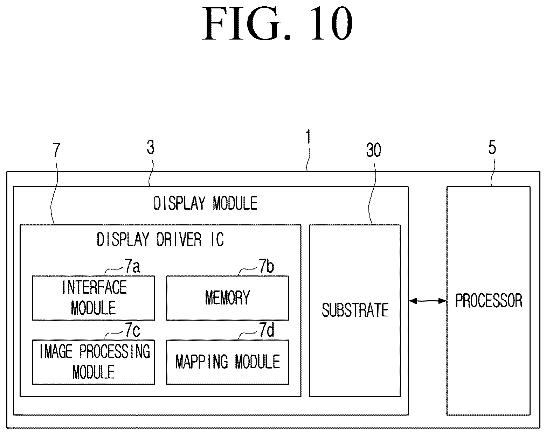

FIG. 10 is a block diagram illustrating a display device according to one or more embodiments.

Referring to FIG. 10, the display device 1 may include a display module 3 and a processor 4. The display module 3 may include a substrate 30 and a display driver integrated circuit (IC) 7 for controlling the substrate 30.

The processor 4 may be implemented as a digital signal processor (DSP) processing digital image signals, a microprocessor, a graphics processing unit (GPU), an artificial intelligence (AI) processor, a neural processing unit (NPU), and a time controller (TCON). However, the disclosure is not limited thereto, and the processor 4 may include one or more of a central processing unit (CPU), a micro controller unit (MCU), a micro processing unit (MPU), a controller, an application processor (AP) or a communication processor (CP), and an ARM processor, or may be defined by the terms. Also, the processor 4 may be implemented as a system on chip (SoC) having a processing algorithm stored therein or large scale integration (LSI), or implemented in the form of an application specific integrated circuit (ASIC) or a field programmable gate array (FPGA).

The processor 4 may control hardware or software components connected to the processor 4 by driving an operating system or an application program, and perform various types of data processing and operations. Also, the processor 4 may load an instruction or data received from at least one of other components on volatile memory and process them, and store various data in non-volatile memory.

The display driver IC 7 may include an interface module 7a, memory 7b (e.g.: buffer memory), an image processing module 7c, or a mapping module 7d. The display driver IC 7 may receive, for example, image data or image information including an image control signal corresponding to an instruction for controlling the image data from another component of the display device 1 through the interface module 7a. For example, according to an embodiment, the image information may be received from the processor 4 (e.g.: a main processor (e.g.: an application processor)) or an auxiliary processor (e.g.: a graphics processing device) that is independently operated from the function of the main processor.

The display driver IC 7 may communicate with a sensor module through the interface module 7a. Also, the display driver IC 7 may store at least some of the received image information in the memory 7b, for example, in a frame unit. The image processing module 7c may, for example, perform pre-processing or post-processing (e.g.: adjustment of a resolution, brightness, or a size) of at least some of the image data based at least partially on the characteristics of the image data or the characteristics of the substrate 30. The mapping module 7d may generate a voltage value or a current value corresponding to the image data that was pre-processed or post-processed through the image processing module 7c. According to an embodiment, generation of a voltage value or a current value may be performed, for example, based at least partially on the attributes of the pixels of the substrate 30 (e.g.: arrangement of the pixels (an RGB stripe or a pentile structure), or the sizes of each of the subpixels). At least some pixels of the substrate 30 may be driven, for example, based at least partially on the voltage value or the current value, and accordingly, visual information corresponding to the image data (e.g.: texts, images, or icons) may be displayed through the substrate 30.

The display driver IC 7 may transmit a driving signal (e.g.: a driver driving signal, a gate driving signal, etc.) to the display based on the image information received from the processor 4.

The display driver IC 7 may display an image based on an image signal received from the processor 4. As an example, the display driver IC 7 may generate a driving signal of a plurality of subpixels based on an image signal received from the processor 4, and control light emission of the plurality of subpixels based on the driving signal and thereby display an image.

According to one or more embodiments, the display module 3 may further include a touch circuit. The touch circuit may include a touch sensor and a touch sensor IC for controlling it. The touch sensor IC may, for example, control the touch sensor for detecting a touch input or a hovering input for a designated location of the substrate 30. For example, the touch sensor IC may detect a touch input or a hovering input by measuring the change of a signal (e.g.: a voltage, a light amount, a resistance, or a charge amount) for a designated location of the substrate 30. The touch sensor IC may provide information about the detected touch input or hovering input (e.g.: the location, the area, the pressure, or the time) to the processor 4. According to an embodiment, at least a part of the touch circuit (e.g.: the touch sensor IC) may be included as a part of the display driver IC 7 or the substrate 30, or a part of another component arranged on the outside of the display module 3 (e.g.: an auxiliary processor).

According to one or more embodiments, a pixel driving method of the display module 3 may be an active matrix (AM) driving method or a passive matrix (PM) driving method.

According to one or more embodiments, the display device 1 may include a display module 3. The display module 3 may display various images. Here, an image may include a still image and/or a moving image. The display module 3 may display various images such as a broadcasting content, a multimedia content, etc. Also, the display module 3 may display a user interface and icons.

According to one or more embodiments, the display module 3 may be installed and applied on wearable devices, portable devices, handheld devices, and electronic products or electronic components which need various kinds of displays.

According to one or more embodiments, the display device 1 may include a plurality of display modules 3. The plurality of display modules 3 may be physically connected and implement a large size display (e.g., a large format display). The large size display may be a monitor for personal computers, a high resolution TV, signage (or, digital signage), or an electronic display wherein a plurality of display modules are connected in a grid arrangement.

In the above, the disclosure has been shown and described with reference to various embodiments, but it should be understood by a person having ordinary knowledge in the art that various modifications may be made in forms and details without departing from the idea and the scope of the disclose defined by the appended claims and equivalents thereof.

Also, in the above, preferred embodiments of the disclosure have been shown and described, but the disclosure is not limited to the aforementioned specific embodiments, and it is apparent that various modifications may be made by a person having ordinary knowledge in the art to which the disclosure belongs, without departing from the gist of the disclosure as claimed by the appended claims. Further, it is intended that such modifications are not to be interpreted independently from the technical idea or prospect of the disclosure.

## Claims

1. A display module comprising:
a glass substrate;
a thin film transistor (TFT) layer formed on one surface of the glass substrate; and
a plurality of light-emitting diodes arranged on the TFT layer,
wherein the TFT layer comprises:
a plurality of pixel circuits which are arranged in a grid and are for driving the plurality of light-emitting diodes; and a plurality of gate in panel (GIP) circuits which are spaced apart from one another along a thickness direction of the TFT layer with respect to the plurality of pixel circuits.

2. The display module of claim 1, wherein
the TFT layer comprises a plurality of metal layers which are sequentially stacked to be spaced apart,
each of the plurality of pixel circuits is formed on some of the plurality of metal layers, and
the plurality of GIP circuits are formed on the remaining layers of the plurality of metal layers.

3. The display module of claim 1,
wherein the TFT layer comprises a first metal layer, a second metal layer, a third metal layer, and a fourth metal layer which are sequentially stacked to be spaced apart,
each of the plurality of pixel circuits is formed on the first metal layer and the second metal layer, and
each of the plurality of GIP circuits is formed on the third metal layer and the fourth metal layer.

4. The display module of claim 3,
wherein the plurality of metal layers further comprise a fifth metal layer which is stacked to be spaced apart on the upper side of the fourth metal layer, and
on the fifth metal layer, a pixel electrode to which the plurality of light-emitting diodes are electrically connected is formed.

5. The display module of claim 1,
wherein the plurality of pixel circuits comprise an LTPS TFT, and
the plurality of GIP circuits comprise an oxide TFT.

6. The display module of claim 1,
wherein the plurality of pixel circuits comprise an LTPS TFT, and
the plurality of GIP circuits comprise an LTPS TFT.

7. The display module of claim 1,
wherein the plurality of pixel circuits comprise an oxide TFT, and
the plurality of GIP circuits comprise an oxide TFT.

8. The display module of claim 1,
wherein the plurality of light-emitting diodes are micro LEDs.

9. The display module of claim 1,
wherein the plurality of GIP circuits are micro LEDs of which one portion overlaps with one of the plurality of light-emitting diodes.

10. A display module comprising:
a substrate;
a thin film transistor (TFT) layer which is provided on one surface of the substrate, and comprises a plurality of pixel circuits and at least one gate in panel (GIP) circuit arranged at a different height from the plurality of pixel circuits; and
a plurality of micro LEDs arranged on the plurality of TFT layers.

11. The display module of claim 10,
wherein the TFT layer further comprises:
a first metal layer on which the plurality of pixel circuits are formed anda second metal layer stacked to be spaced apart from the first metal layer.

12. The display module of claim 11,
wherein the TFT layer further comprises:
three or more metal layers on which the at least one GIP circuit is formed.

13. The display module of claim 10,
wherein the plurality of pixel circuits comprise an LTPS TFT.

14. The display module of claim 13,
wherein the at least one GIP circuit comprises an oxide TFT or an LTPS TFT.

15. The display module of claim 10,
wherein the plurality of pixel circuits and the at least one GIP circuit comprise an oxide TFT.
